Europäisches Patentamt

European Patent Office

Office européen des brevets

(19)

(11) **EP 0 474 487 B1**

(12) **EUROPEAN PATENT SPECIFICATION**

(45) Date of publication and mention
of the grant of the patent:
**19.03.1997 Bulletin 1997/12**

(51) Int Cl.6: **H01J 37/20**, G01B 11/27,
H01L 21/00

(21) Application number: **91308120.4**

(22) Date of filing: **04.09.1991**

(54) **Method and device for optically detecting position of an article**

Verfahren und Vorrichtung zum optischen Detektieren der Lage eines Gegenstandes

Procédé et dispositif pour détecter la position d'un article par voie optique

(84) Designated Contracting States:
**DE FR GB IT NL**

(30) Priority: **07.09.1990 JP 238186/90**
**30.11.1990 JP 339908/90**

(43) Date of publication of application:
**11.03.1992 Bulletin 1992/11**

(73) Proprietor: **CANON KABUSHIKI KAISHA**
**Tokyo (JP)**

(72) Inventors:
• **Yoshii, Minoru, Canon Kabushiki Kaisha**
**Ohta-ku, Tokyo (JP)**
• **Saitoh, Kenji, Canon Kabushiki Kaisha**
**Ohta-ku, Tokyo (JP)**
• **Suda, Shigeyuki, Canon Kabushiki Kaisha**
**Ohta-ku, Tokyo (JP)**
• **Abe, Naoto, Canon Kabushiki Kaisha**
**Ohta-ku, Tokyo (JP)**

(74) Representative:
**Beresford, Keith Denis Lewis et al**
**BERESFORD & Co.**
**2-5 Warwick Court**
**High Holborn**
**London WC1R 5DJ (GB)**

(56) References cited:
**EP-A- 0 094 041          US-A- 4 037 969**
**US-A- 4 928 008**

# Description

This invention relates to a method and device for optically detecting the position of an article very precisely. More particularly, the invention is concerned with a position detecting method and device suitably applicable to a semiconductor device manufacturing exposure apparatus, for example, for bringing a mask or a reticle and a wafer into a predetermined positional relationship before lithographically transferring a fine electronic circuit pattern of the mask or reticle onto the wafer.

In exposure apparatuses for use in the manufacture of semiconductor devices, the relative alignment of a mask and a wafer and the setting of interval therebetween are important factors in respect to ensuring improved performance. Particularly, as for alignment and interval setting systems employed in recent exposure apparatuses, submicron alignment and interval setting accuracies or more strict accuracies are required in consideration of the demand for higher degree of integration of each semiconductor device.

To this end, usually, the interval of a mask and a wafer is measured by using an interval measuring device and, after interval control to set a predetermined interval, the mask-to-wafer alignment is effected. In many types of alignment systems, features called "alignment patterns" are provided on a mask and a wafer and, by utilizing positional information obtainable from these patterns, the mask and wafer are aligned. As for the manner of executing the alignment, as an example there is a method wherein the amount of relative deviation of these alignment patterns is detected on the basis of image processing. Another method is proposed in U.S. Patent No. US-A-4,037,969 or Japanese Laid-Open Patent Application, Laid-Open No. Sho JP-A-56-157033, wherein so-called zone plates are used as alignment patterns upon which light is projected and wherein the positions of light spots formed on a predetermined plane by lights from the illuminated zone plates are detected.

Generally, an alignment method utilizing a zone plate is relatively insensitive to any defect of an alignment pattern and therefore assures relatively high alignment accuracies, as compared with an alignment method simply using a traditional alignment pattern.

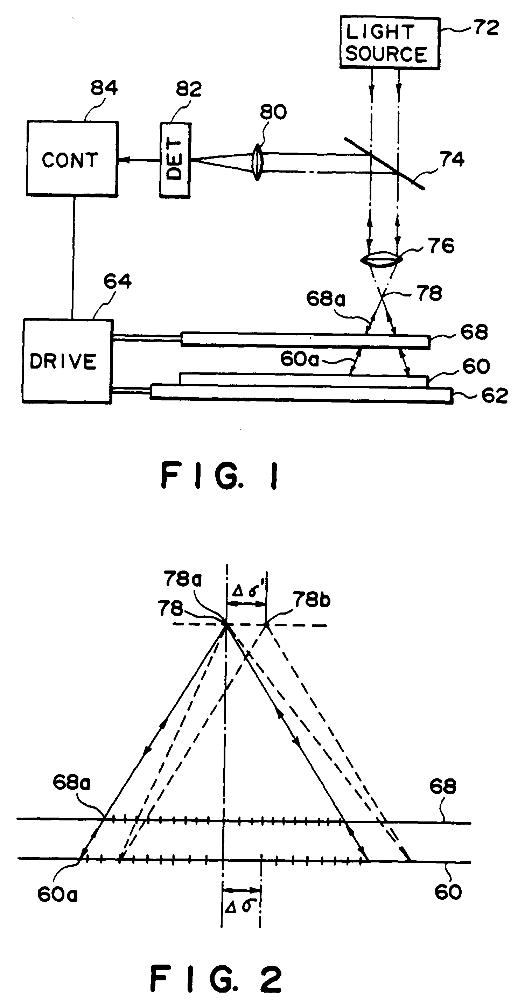

Figure 1 is a schematic view of a known type alignment system utilizing zone plates.

In Figure 1, a parallel light emanating from a light source 72 passes through a half mirror 74 and is focused at a point 78 by a condensing lens 76. Thereafter, the light illuminates a mask alignment pattern 68a on a mask 68 and an alignment pattern 60a on a wafer 60 which is placed on a support table 62. Each of these alignment patterns 68a and 60a is provided by a reflection type zone plate and functions to form a spot of focused light on a plane perpendicular to an optical axis which contains the point 78. The amount of relative deviation of the positions of these light spots formed on that plane is detected, by directing the focused beams to a detection plane 82 by means of the condensing lens 76 and another lens 80.

In accordance with an output signal from the detector 82, a control circuit 84 actuates a driving circuit 64 to relatively align the mask 68 and the wafer 60.

Figure 2 illustrates an imaging relationship of lights from the mask alignment pattern 68a and the wafer alignment pattern 60a shown in Figure 1.

In Figure 2, a portion of the light divergently advancing from the point 78 is reflectively diffracted by the mask alignment pattern 68a and forms a spot 78a of focused light at or adjacent to the point 78, the spot representing the mask position. Another portion of the light passes through the mask 68 in the form of a zero-th order transmission light and is projected upon the wafer alignment pattern 60a on the wafer 60 surface with its wavefront being unchanged. The incident light is reflectively diffracted by the wafer alignment pattern 60a and then passes again through the mask 68 in the form of a zero-th order transmission light, and finally is focused in the neighborhood of the point 78 to form a spot 78b of focused light, representing the wafer position. In the illustrated example, when the light diffracted by the wafer 60 forms a spot, the mask 68 functions merely as a transparent member.

The position of the spot 78b formed by the wafer alignment pattern 60a in the described manner represents a deviation $\Delta\sigma$, in the plane perpendicular to the optical axis containing the point 78, of an amount corresponding to the amount of deviation $\Delta\sigma$ of the wafer 60 with respect to the mask 68, in a direction (lateral direction) along the mask or wafer surface.

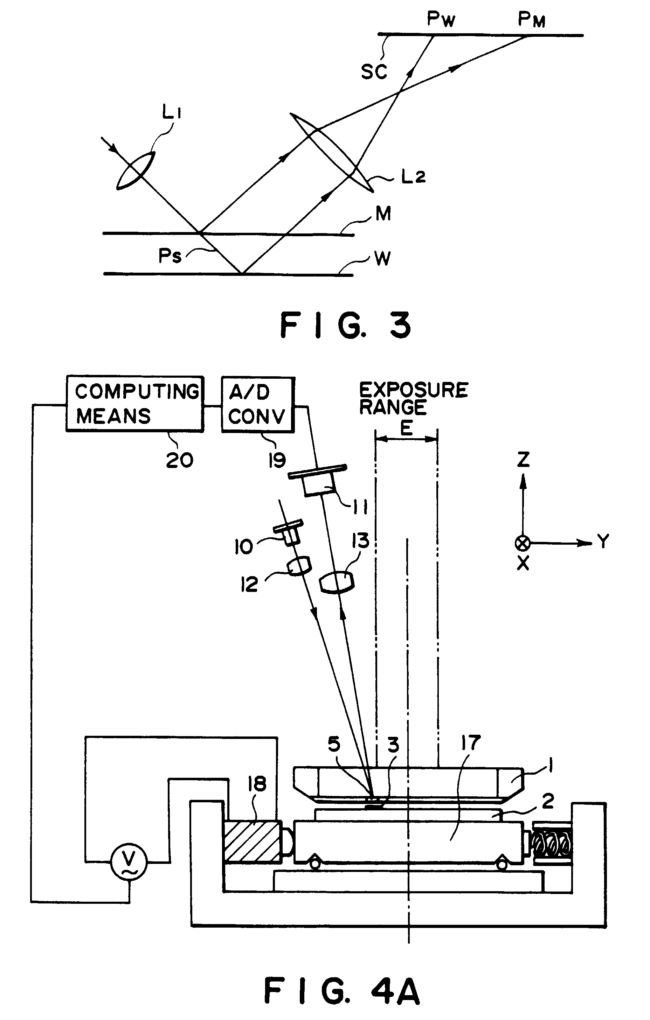

Figure 3 is a schematic view of an interval measuring device such as proposed in Japanese Laid-Open Patent Application, Laid-Open No. JP-A-61-111402, wherein a mask (first object) M and a wafer (second object) W are disposed opposed to each other and, by means of a lens L1, light is focused at a point Ps which is between the mask M and the wafer W.

Here, the light from the lens L1 is reflected by the mask M surface and the wafer W surface, respectively and, through another lens L2, the reflected lights are projected on points Pw and Pm on a screen S surface, respectively. The interval between the mask M and the wafer W is detected by detecting the spacing between the convergent points Pw and Pm of the lights projected on the screen S surface.

In the above-described arrangements, usually a coherent beam such as a laser beam is used to attain enhanced sensitivity. The inventors of the subject application have found specific inconveniences involved in these arrangement. Namely, as a consequence of use of a coherent beam, a speckle pattern (speckle noise) is produced by interference of scattered beams from the mask or wafer surface, and such speckle pattern is projected on the detection plane or a screen surface. Due to the superposition of such a speckle pattern on the light spot converged on the screen or detection plane, the intensity distribution of the light spot is disturbed which prevents accurate detection of the position of the light spot. This results in an error and in a degraded precision for the detection of a positional deviation or an interval of the mask and the wafer.

According to the invention there is provided a position detecting method having the features of claim 1 of the accompanying claims.

The position or level of a substrate may be determined in the present invention on the basis of (1) the centre of gravity position or a peak position of an intensity distribution to be defined by superposition of a plural intensity distributions, or (2) centre of gravity positions or peak positions of plural intensity distributions, respectively. When the method (1) is to be used, preferably CCD sensor means may be used to accumulate electric charges for the superposition of intensity distributions.

An improved semiconductor device manufacturing method can be provided by the detection and correction of a positional deviation of a wafer with respect to a predetermined position, in accordance with an aspect of the present invention.

Also, an improved exposure apparatus can be provided by using a mechanism for detecting and correcting a positional deviation of a wafer with respect to a predetermined position, in accordance with an aspect of the present invention.

These and other objects, features and advantages of the present invention will become more apparent upon a consideration of the following description of the preferred embodiments of the present invention taken in conjunction with the accompanying drawings in which :

Figures 1 and 2 are schematic views of a position detecting system of known type, using zone plates.

Figure 3 is a schematic view of an interval measuring system of known type.

Figure 4A is a schematic side sectional view of a main portion of an exposure apparatus into which a position detecting system according to a first embodiment of the present invention is incorporated.

Figure 4B is an extended view of an optical arrangement of the position detecting system of the Figure 4A embodiment.

Figure 5 is an enlarged top plan view of an alignment mark pattern used in the Figure 4A embodiment.

Figures 6 and 7 are graphs each showing an intensity distribution of alignment light incident on a detector surface of Figure 4A.

Figure 8 is a perspective view schematically showing the detector of Figure 4A.

Figure 9 is a timing chart, showing the relationship between an applied voltage to a driving means of the first embodiment and an output signal from the detector.

Figures 10A, 10B and 10C are schematic views, respectively, showing a second embodiment of the present invention.

Figures 11A and 11B are schematic views, respectively, showing a third embodiment of the present invention.

Figure 12 is a schematic view for explaining relative shift of a light spot of alignment light and an alignment mark.

Figure 13 is a block diagram, showing a modified form of the third embodiment of the present invention.

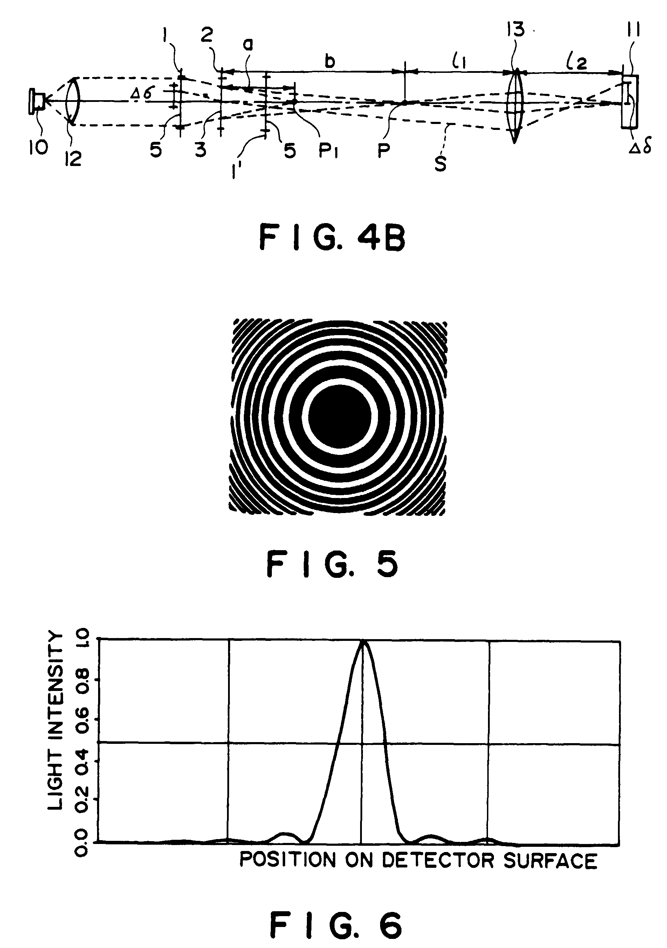

Figures 4A and 4B show a position detecting system according to a first embodiment of the present invention, wherein Figure 4A is a sectional view of a main portion of an exposure apparatus into which the position detecting system of this embodiment is incorporated. In the case shown in Figure 4B, any positional deviation in respect to an X-axis direction is to be detected. In this embodiment, the invention is applied to a semiconductor device manufacturing exposure apparatus of proximity type.

Denoted at 1 is a mask (first object) having an electronic circuit pattern formed thereon, and denoted at 2 is a wafer (second object) onto which the circuit pattern of the mask is to be transferred with the use of an exposure beam. Through this exposure and transfer process, semiconductor devices can be manufactured from the wafer. Denoted at 5 is an alignment mark formed on the mask 1 surface, and denoted at 3 is an alignment mark formed on the wafer 2 surface. Each of these alignment marks 5 and 3 is provided by a grating lens or a Fresnel zone plate, for example, having an optical power at least with respect to the positional deviation detecting direction (X-axis direction in this example) and having a one-dimensional or two-dimensional lens function.

In this embodiment, a relative positional deviation of the mask 1 and the wafer 2 with respect to the X-axis direction can be detected by using the light subjected to the wavefront transformation through the alignment marks 5 and 3. Figure 5 shows an example of mark pattern of the alignment mark 3 or 5 where a zone plate is used therefor.

Denoted at 10 is a laser light source such as a semiconductor laser, which emits coherent light of good directivity. Light projecting lens 12 receives the laser light from the laser source 10 and transforms it into a parallel light which is then projected onto the alignment mark 5 on the mask 1 surface. Detector 11 comprises a CCD line sensor, for example. Light receiving lens 13 receives the light from the mask 1 surface and directs the same to the detector 11. The wafer 2 is placed on a wafer stage 13 which is driven by a stage driving means 18. By this stage driving means 18, the wafer stage 17 can be oscillated in the Y-axis direction in this example, with short stroke, to be described later. Reference character E denotes the exposure range through which the exposure beam passes.

In this embodiment, the laser light from the laser source 10 is transformed by the light projecting lens 11 into a parallel light which is then incident on the alignment mark 5 on the mask 1 surface. Then, the light is subjected to the wavefront transformation (i.e. transmissive diffraction) through the alignment mark 5 and is inputted to the alignment mark 3 on the wafer 2 surface. Then, a portion of the light influenced by the optical function (i.e. reflective diffraction) of the alignment mark 3, goes through the mask 1 without being affected by the diffracting function of the alignment mark of the mask 1, and it is collected by the light receiving lens 13 and is incident on the light receiving surface of the detector 11 as "alignment light".

Figure 6 shows the intensity distribution of such an alignment light incident on the detector 11 surface. The alignment light incident on the detector 11 surface is photoelectrically converted into a signal of a waveform such as shown in Figure 3, which is outputted from the detector 11. The output signal from the detector 11 is analog-to-digital converted through an analog-to-digital converter (A/D converter) 19 into a digital signal which is applied to a computing means 20. In response, the computing means 20 calculates the position of incidence (centre of gravity position) of the alignment light on the detector 11 and, from the detected position, it determines a relative positional deviation of the mask 1 and the wafer 2 in the X-axis direction (along the X-Y plane).

Assuming now that the mask 1 and the wafer 2 have a relative deviation $\Delta\sigma$ in the X direction as shown in Figure 4B, that the distance from the wafer 2 to the point P1 of light convergence as determined by the focal length of the mask alignment mark 5 is $\underline{a}$, that the distance to the point P2 of convergence of the light reflectively diffracted by the wafer alignment mark 3 and passing through the mask alignment mark 5 is $\underline{b}$, and that the lens 13 has a unit imaging magnification (= 1x), then on the detector 11 surface there occurs a displacement $\Delta\delta$ of the centre of gravity of the spot of converged alignment light S which can be expressed as follows:

$$\Delta\delta = \Delta\sigma \times (b/a + 1) \qquad (1)$$

Thus, on the detector 11 surface, the positional deviation $\Delta\sigma$ is magnified by "b/a + 1".

If a = 0.5 mm and b = 50 mm, then from equation (1) the positional deviation is magnified by 101x.

Here, as seen from equation (1), there is a proportional relationship between the positional deviation $\Delta\sigma$ and the displacement $\Delta\delta$ of the gravity center position. If the detecting means (11, 19, 20) has a resolution of 0.1 micron, then the resolution for the positional deviation $\Delta\sigma$ is 0.001 micron.

In this embodiment, the term "centre of gravity of light" means such a point that, when on the light receiving surface of the detector a position vector of each point on that surface is multiplied by the light intensity of that point and the thus obtained products are integrated over the entire section, the integrated value has a "zero vector". As an alternative, a peak point of light intensity may be used as a representative point.

Details of the principle of the positional deviation detection as described above and used in this embodiment of the present invention, are explained in Japanese Laid-Open Patent Application No. JP-A-01-233305 or No. 02-1506 filed in Japan in the name of the assignee of the subject application.

Important features of this embodiment of the present invention will now be explained.

Generally, if a laser beam is incident on a portion of the mask surface having a small surface irregularity or on an aluminum-coated portion of the wafer surface having a small surface irregularity ($100 \times 10^{-9}$m (1000 angstroms) or less), there occurs scattering of light which causes speckle noise to be superposed on the alignment light upon the detector 11 surface. The intensity of such speckle noise resulting from the scattered light is higher with larger coherency of a laser light source used, and the intensity distribution of the speckle noise changes in dependence upon the relative position of the wafer to the mask or the interval between the mask and the wafer. Unless there occurs a relative change in the laser light source 10, in the mask 1 or in the wafer 2, such noise light does not change and, thus, even the electrical averaging with time does not effectively avoid the noise light.

Further, since the light causing the speckle noise has a spot diameter approximately equal to that of the alignment light, when the same is superposed on the alignment light on the detector 11 surface, it can not be separated spatially or separated with respect to the spatial frequency, from the alignment light.

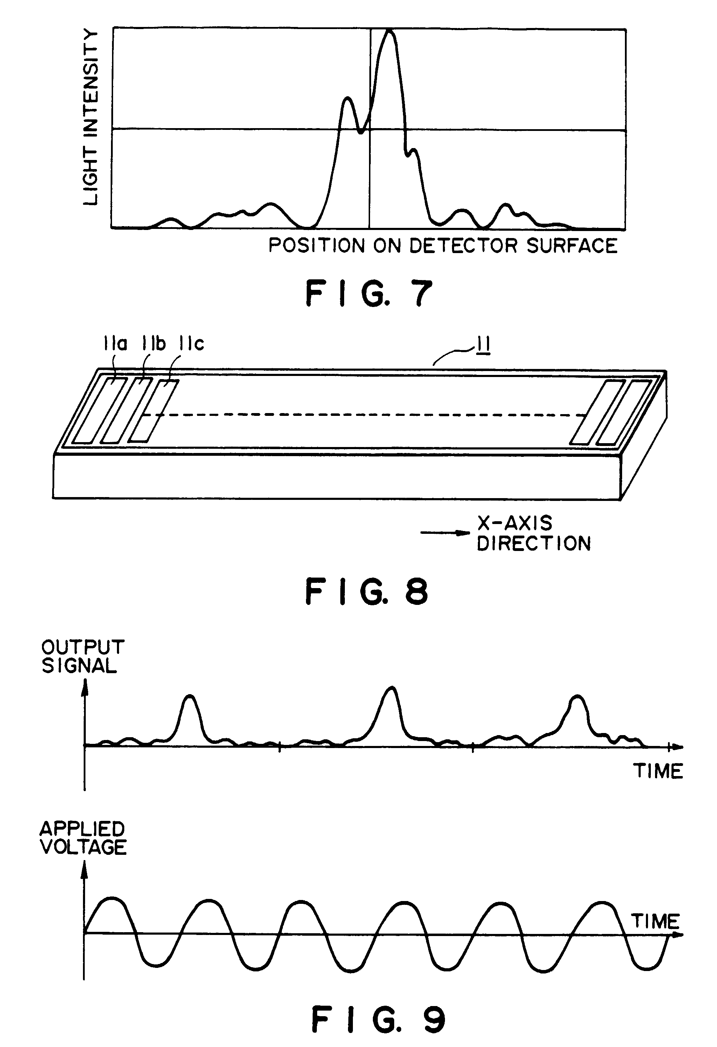

This results in disturbance of the waveform of the output signal from the detector 11, such as shown in Figure 7, and in a shift of the centre of gravity position of the incident light on the detector 11 surface, causing an error in the detection of the positional deviation.

Particular attention has been paid to this in the present invention and, in this embodiment, at the time of detection of positional deviation, at least one of the mask 1 and the wafer 2 is oscillatingly shifted by small amount relative to the incidence beam (alignment light) in a non-sensitive direction along the surface of the surface of the substrate while mounting the angle of incidence of the light beam in the substrate constant (non-detecting direction), so as to attain spatial averaging of speckle noise (speckle pattern) produced by the relatively shifting scattered light and superposed on the alignment light.

As an example, the wafer may be oscillatingly shifted by using the wafer driving means 18, in a direction (Z-axis direction) along which the wafer is opposed to the mask, and within a range of $100 \times 10^{-9}$m - $200 \times 10^{-9}$m (1000 - 2000 Angstroms). As shown in Figure 8, the detector 11 may comprise a number of light receiving elements (11a, 11b, 11c,...) which are arrayed along the positional deviation detecting direction (X direction). Thus, at the time of positional deviation detection, the wafer 2 may be oscillated in a non-sensitive direction (i.

e. Z direction in this example) so as not to affect against the positional deviation detection. Substantially the same advantageous effect is attainable by oscillating the wafer in the Y direction.

The relative oscillation of the mask and/or the wafer does not cause a change in the centre of gravity position of the alignment light with respect to the positional deviation detecting direction (X direction). Thus, by averaging with time the output signals (waveforms) from the detector 11, it is possible to prevent unwanted shift of the centre of gravity position of the alignment light due to the speckle noise and to avoid an error in the positional deviation detection. On the basis of the positional deviation detected, it is possible to correctly align the mask and the wafer to remove their relative positional deviation.

Figure 9 is a timing chart showing the relationship between the output signal from the detector and the electric voltage applied to the wafer driving means 18, where a piezoelectric device is used as the driving means 18 to oscillate the wafer stage 17 in the Y direction while a CCD sensor is used as the detector.

It is seen from Figure 9 that the electric charges produced in response to the alignment light and the speckle noise during oscillation of the stage 17 by the piezoelectric device, are accumulated by the CCD and the accumulated charges are outputted as a single output signal. This reduces the effect of the speckle noise (the intensity distribution of the speckle noise is averaged into an approximately flat distribution) and, therefore, it is possible to obtain a signal that correctly represents the relative position of the mask and the wafer. The charge accumulation time of the CCD (signal output timing) can be appropriately set by using a CCD driver.

A bimorph element may be used in the present invention as the wafer driving means 18, with substantially the same advantageous effects.

While in the above-described embodiment the invention has been explained with reference to a case where a positional deviation of a mask and a wafer along the X-Y plane is detected and corrected, the present invention is applicable also to a case where an error or deviation of the interval between the mask and the wafer, from a preset reference interval, is to be detected.

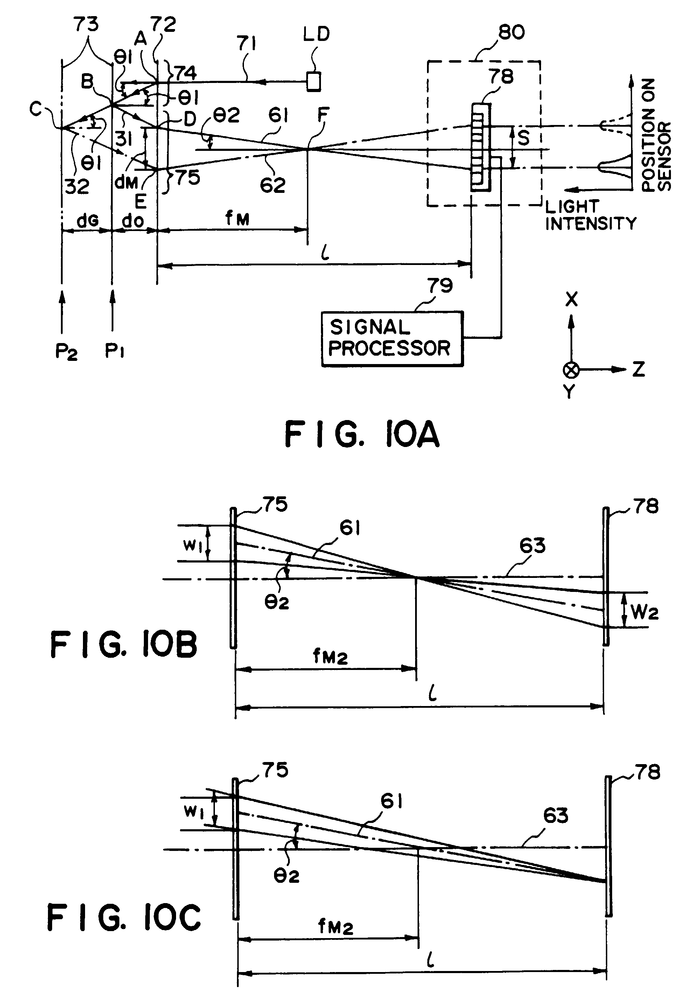

Figure 10A is a schematic view of an optical arrangement of an embodiment of the present invention to be incorporated into a semiconductor device manufacturing exposure apparatus of proximity type, for measuring the interval between a mask and a wafer. Figures 10B and 10C are schematic views, respectively, each showing optical paths in a portion of Figure 10A.

In Figures 10A - 10C, only a mask, a wafer, optical systems and light receiving means are illustrated. Actually, however, the mask and the wafer are placed in an exposure apparatus such as shown in Figure 4A, and also the optical systems and the light receiving means are accommodated in such exposure apparatus. Thus, an output of the light receiving means is applied to a computing means such as at 20 in Figure 4A, and a driving means such as at 18 drives a wafer stage such as at 17 so as to oscillatingly shift the wafer in a Y direction, in this example, which is perpendicular to the plane of incidence (X-Z plane) of an input light obliquely incident on the wafer.

In Figures 10A - 10C, denoted at 71 is a coherent light emanating from a coherent light source LD such as a He-Ne laser or a semiconductor laser, for example; denoted at 72 is a mask (first object); and denoted at 73 is a wafer (second object). The mask 72 and the wafer 73 are disposed opposed to each other, initially with a spacing d0. Denoted at 74 and 75 are first and second physical optic elements (alignment marks) each being formed on a scribe line on the mask 72 surface and each being provided by a diffraction grating, a zone plate or a Fresnel lens, for example.

Light receiving means 78 comprises a line sensor or a PSD (position sensitive detector), for example, and it serves to detect the centre of gravity position of an incident light. Signal processing circuit 79 serves to process a signal from the light receiving means 78 to determine the gravity center position of the light incident on the detector 78 surface and also to calculate the interval between the mask 72 and the wafer 73 in the manner to be described later. Optical probe 80 includes the light receiving means 78 and, if necessary, the signal processing circuit 79, and it is relatively movable relative to the mask 72 or the wafer 73.

In this embodiment, the light (wavelength $\lambda = 830$ nm) 71 from a semiconductor laser LD is incident on a point A on a Fresnel zone plate (first physical optic element) 74 provided on the mask 72, whereby the incident light is diffracted. Diffraction light of a predetermined order or orders, emanating from the first Fresnel zone plate 74 at an angle $\theta_1$, is reflected at a point B on the wafer 73 surface (at point C as the wafer 73 is at a position P2). In Figure 10A, reference numeral 31 denotes the reflection light from the wafer 73 as the same is at a reference position P1 close to the mask 72, while reference numeral 32 denotes the reflection light from the wafer as the same is at the position P2 displaced from the position P1 by a distance dG. In this embodiment, the wafer 73 has no alignment mark but a reflective surface thereof is used.

Then, the reflection light from the wafer 73 is incident on a point D on a second Fresnel zone plate 75 on the mask (first object) 72 (or on a point E as the wafer 72 is at the position P2). The second Fresnel zone plate 75 has such optical function that, in response to the position of incidence of the input light thereon, the angle of emission of the diffraction light emanating therefrom changes.

Diffraction light 61 of a predetermined order or orders emanating from the second Fresnel zone plate 75 at an angle $\theta_2$ (or diffraction light 62 as the wafer 73 is at the position P2), is incident on the detecting means 78 surface. The detecting means 78 may comprise a CCD sensor, producing an output signal corresponding to an intensity distribution of a received light.

The output signal from the detecting means is processed to determine the centre of gravity position of the light intensity distribution of the input light 61 (light 62 as the wafer 73 is at the position P2) incident on the light receiving means 78 surface, and from this, the interval between the mask 72 and the wafer 73 is determined by calculations. Then, the wafer stage 17 is moved upwardly or downwardly to adjust the interval of the mask and the wafer.

Each of the first and second Fresnel zone plates 74 and 75 provided on the mask 72 has a preset pitch, and the angle (θ1 or θ2) of diffraction of the light, of predetermined diffraction order or orders, incident on that zone plate is also preset.

Assuming now that the second Fresnel zone plate 75 has a focal length of fM2 (μm = micron), while it may be either positive or negative, and that the distance from the second Fresnel zone plate 75 to a light evaluation plane equivalent to the detecting means 78 surface is $\ell$, then displacement S of the gravity center position of the light on the light receiving means 78 surface, from the position as assumed when the wafer 73 is at its reference position P1, to be caused in response to the shift of the wafer 73 from the reference position P1 by a distance dG, is given by the following equation:

$$S = 2 \times dG \times (\ell - fM1)/fM2 \times \tan\theta1 \qquad (2)$$

The gravity center position (reference point) as the wafer 73 is at the reference position P1 can be detected beforehand. Thus, by detecting during actual interval measurement a displacement of the gravity center position from the reference point and by substituting the detected displacement S into equation (2), it is possible to determine the displacement dG of the wafer 73 from the position P1, in the direction of the interval.

The interval d0 of the mask and the wafer as the wafer is at the position P1 may be set by using a separate measuring means.

In this embodiment, like the first embodiment, for avoiding the adverse effect of the noise light due to speckle scattered light, within the charge accumulation time of the light receiving means 78 the driving means 18 oscillates the wafer 73 with a short stroke in a non-sensitive direction (i.e. Y direction), to the interval error detecting direction (Z direction). By using a signal thus obtained, high precision interval measurement is assured.

In the embodiments described hereinbefore, an input light beam is held fixed while, on the other hand, at least one of the mask and the wafer is oscillated in a non-sensitive direction, not affecting the position detection. This effectively avoids the adverse effect of speckle noise resulting from the light scatted by an irregular surface portion of the mask or the wafer, where a light source such as a laser having good coherency is used. Also, based on the averaging effect, further improvement of the detection precision is assured. Therefore, the present invention in these aspects assures a position detecting system by which a relative positional deviation of a mask and a wafer or a change in the interval therebetween can be detected very precisely.

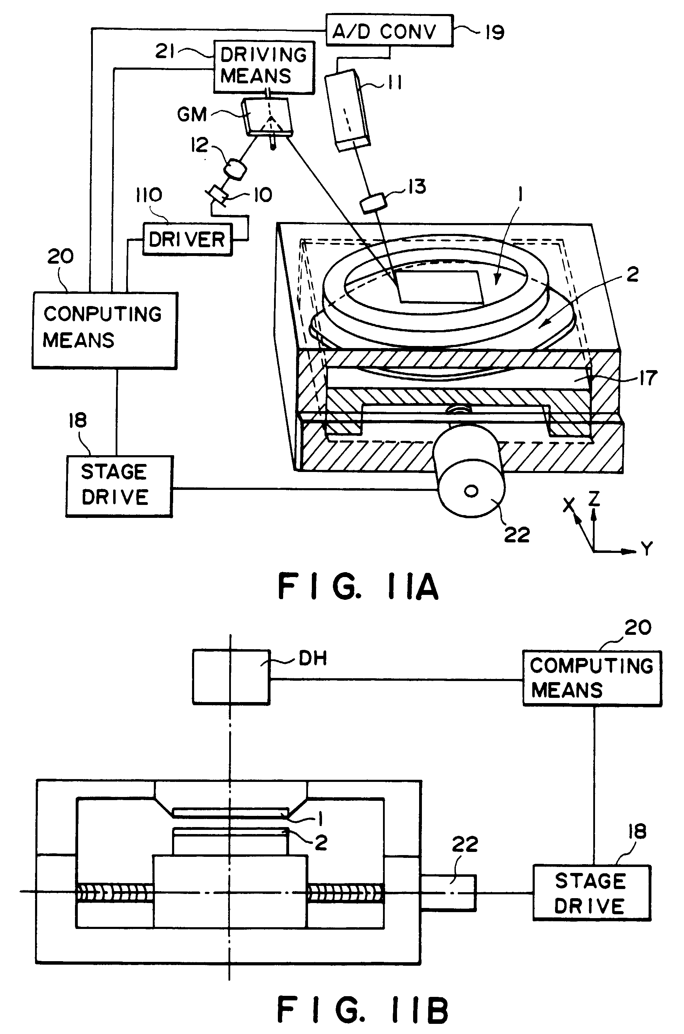

Figures 11A and 11B show a third embodiment of the present invention. Since this embodiment has optical paths like those of the embodiment described with reference to Figure 4B, description of the present embodiment will be made also with reference to Figure 4B.

In the present embodiment, the invention is applied to a semiconductor device manufacturing exposure apparatus of proximity exposure type.

Denoted at 1 is a mask (first object) having an electronic circuit pattern formed thereon, and denoted at 2 is a wafer (second object). Denoted at 5 is an alignment mark formed on the mask 1 surface, and denoted at 3 is an alignment mark formed on the wafer 2 surface. Each of these alignment marks 5 and 3 is provided by a grating lens or a Fresnel zone plate, for example, having a one-dimensional or two-dimensional lens function, like the alignment marks of the mask and the wafer as described with reference to Figures 4A and 4B.

In this embodiment, like the Figure 4A/4B embodiment, a relative positional deviation of the mask 1 and the wafer 2 along the X-Y plane can be detected by using the light subjected to the wavefront transformation through the alignment marks 5 and 3. Thus, the alignment mark 3 or 5 may have a mark pattern such as shown in Figure 5 where a zone plate is used therefor.

Denoted at 10 is a laser light source such as a semiconductor laser, which is driven by a driver 110 and which emits coherent light of good directivity. Collimator lens 12 receives the laser light from the laser source 10 and transforms it into a parallel light which is then projected onto a galvano mirror GM. This mirror can be oscillated with a short stroke to oscillatingly reflect a received light, whereby the alignment mark 5 on the mask 1 can be oscillatingly scanned with this light in a direction (Y direction in this example) perpendicular to the alignment direction (X direction in this example). Detector 11 comprises a CCD line sensor, for example. Light receiving lens 13 receives the light from the mask 1 surface and directs the same to the detector 11. The wafer 2 is placed on a wafer stage 17 which is driven by a stage driving means 18 and an actuator 22 such as a motor.

In this embodiment, the mirror GM is pivotally oscillated by small amount by driving means 21, about a rotational shaft which extends in parallel to the alignment direction (X direction) and which passes through the point of reflection on the mirror GM surface of the center beam of the light passed through the collimator lens 12. With the light from the mirror GM, a light spot is formed on the mask 1 surface and, this light spot is scanningly oscillated at a predetermined amplitude and a predetermined period.

In this embodiment, the laser light from the laser source 10 is transformed by the collimator lens 11 into a parallel light which is then incident on mirror GM. Then, by the oscillation of the mirror GM, the alignment mark 5 of the mask 1 is scanned with the light from the mirror GM. Then, the light subjected to the wavefront transformation (i.e. transmissive diffraction) through the alignment mark 5 is inputted to the alignment mark 3 on the wafer 2 surface. Then, a portion of the light influenced by the wavefront transformation action (i.e. reflective diffraction) of the alignment mark 3, goes through the mask 1 without being affected by the diffracting function of the alignment mark of the mask 1, and it is collected by the light receiving lens 13 and is incident on the light receiving surface of the detector 11 as "alignment light".

Such an alignment light incident on the detector 11 surface has an intensity distribution such as shown in Figure 6. The alignment light incident on the detector 11 surface is then photoelectrically converted into a signal of a waveform such as shown in Figure 6, which is outputted from the detector 11. The output signal from the detector 11 is analog-to-digital converted through an analog-to-digital converter (A/D converter) 19 into a digital signal which is applied to a computing means 20. In response, the computing means 20 processes the digital signal and calculates the position of incidence (gravity center position) of the alignment light on the detector 11 and, from the detected position, it determines a relative positional deviation of the mask 1 and the wafer 2 in the X-axis direction (along the X-Y plane).

In response to the signal from the computing means 20, the stage driving means 18 (Figure 11B) moves the wafer stage 17 through the actuator 22, so as to align the mask 1 and the wafer 2 with each other. This is also with the case of the Figure 4A/4B embodiment. Denoted at DH in Figure 11B is a detection head in which the laser light source 10, the mirror GM and the detector 11 of Figure 11A are accommodated.

Assuming now that the mask 1 and the wafer 2 have a relative deviation $\Delta\sigma$ in the X direction as shown in Figure 4B, that the distance from the wafer 2 to the point P1 of light convergence as determined by the focal length of the mask alignment mark 5 is $a$, that the distance to the point P2 of convergence of the light reflectively diffracted by the wafer alignment mark 3 and passing through the mask alignment mark 5 is $b$, and that the lens 13 has a unit imaging magnification (= 1x), then on the detector 11 surface there occurs a displacement $\Delta\delta$ of the gravity center of the spot of converged alignment light S which can be expressed by equation (1) set forth hereinbefore. Thus, on the detector 11 surface, the positional deviation $\Delta\sigma$ is magnified by "b/a + 1".

If a = 0.5 mm and b = 50 mm, then from equation (1) the positional deviation $\Delta\sigma$ is magnified by 101x.

Here, as seen from equation (1), there is a proportional relationship between the positional deviation $\Delta\sigma$ and the displacement $\Delta\sigma$ of the gravity center position. If the detecting means (11, 19, 20) has a resolution of 0.1 μm (micron), then the resolution for the positional deviation $\Delta\sigma$ is 0.001 μm (micron).

In this embodiment, the term "center of gravity of light" means such a point that, when on the light receiving surface of the detector a position vector of each point on that surface is multiplied by the light intensity of that point and the thus obtained products are integrated over the entire section, the integrated value has a "zero vector". As an alternative, a peak point of light intensity may be used as a representative point.

Important features of this embodiment of the present invention will now be explained.

Generally, if a laser beam is incident on a portion of the mask surface having a small surface irregularity or on an aluminum-coated portion of the wafer surface having a small surface irregularity (1000 angstroms or less), there occurs scattering of light which causes speckle noise to be superposed on the alignment light upon the detector 11 surface. The intensity of such speckle noise resulting from the scattered light is higher with larger coherency of a laser light source used, and the intensity distribution of the speckle noise changes in dependence upon the relative position of the wafer to the mask or the interval between the mask and the wafer.

This results in disturbance of the waveform of the output signal from the detector 11, such as shown in Figure 7, and in an apparent shift of the gravity center position of the incident light on the detector 11 surface, causing an error in the detection of the positional deviation.

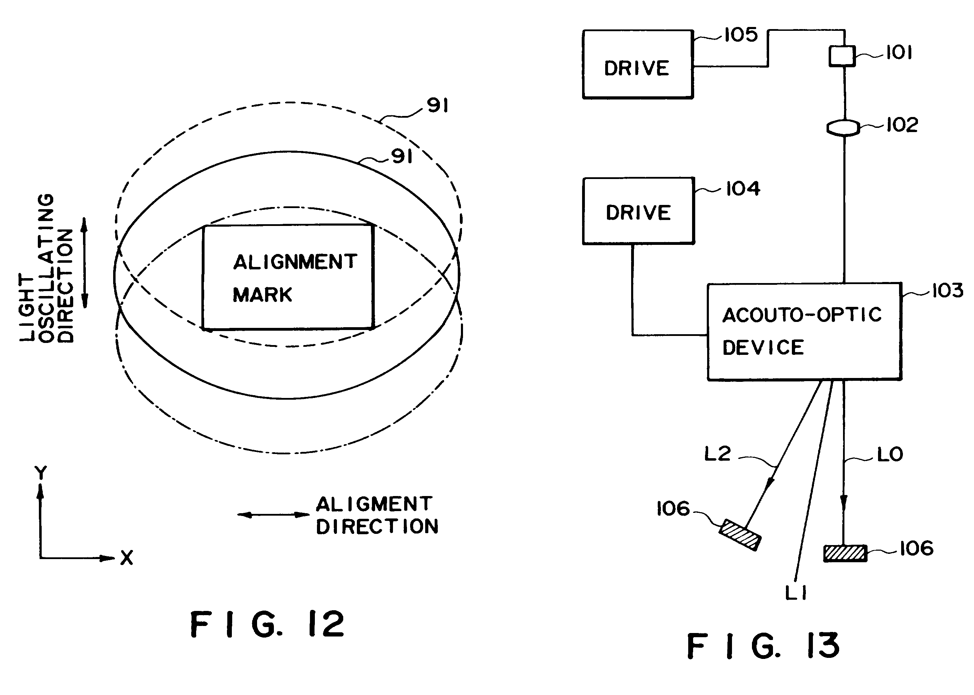

Particular attentions have been paid to this in the present invention and, in this embodiment, at the time of detection of positional deviation and within a preset accumulation time period of the detecting means, the light spot as formed by the alignment light 91 (Figure 12) is oscillated by small amount to oscillatingly scan the alignment mark in a non-sensitive direction (Y direction in this example), so as to attain spatial averaging of speckle noises (speckle patterns) produced by the scattered light and superposed on the alignment light.

As an example, the oscillation may be in a direction (Y-axis direction) perpendicular to the alignment direction (X-axis direction) and within a range of $10^{-7}$ - $2\times10^{-7}$ m (1000 - 2000 angstroms).

As shown in Figure 8, the detector 11 may comprise a number of light receiving elements (11a, 11b, 11c, ...) which are arrayed along the positional deviation detecting direction (X direction). Thus, at the time of positional deviation detection, the spot of the alignment light 91 may be oscillated in a non-sensitive direction (i.e. Y direction in this example).

The amplitude of oscillation of the alignment light in this embodiment is determined by the diameter of the light in a direction perpendicular to the alignment direction, and this oscillation period is determined by the signal (charge) accumulation time period of the detecting means 11.

Generally, each alignment mark has a size of several tens to several hundreds microns so that it can be provided on a scribe line which is defined to allow separation of chips printed in a matrix manner on one wafer. Thus, as regards the the diameter of the alignment light (in a direction perpendicular to the alignment direction), preferably it is large enough to cover the alignment mark as a whole and, additionally, to assure that all the alignment mark area is continuously irradiated by the alignment light. Simultaneously therewith, preferably it is not too large to assure that a sufficient light intensity of a level to be detected on the detecting means 11, is obtained. This is also with the case of the Figure 4A/4B embodiment or the Figure 10 embodiment.

In the present embodiment and in the embodiments described with reference to Figures 4A, 4B, and 10, the amplitude of the small oscillation may preferably be several hundreds microns (maximum) and the oscillation period may be equal to a multiple, by an even number, of the accumulation time period of the detecting means.

In this embodiment, as best seen in Figure 12, the alignment light is relatively oscillated by small amount relative to the mask and the wafer, in a direction (Y direction in this example) not affecting the position detection and, with this oscillation of the alignment light, the light intensity distribution of the speckle noise is averaged. Since the oscillation is in a direction perpendicular to and, thus, not affecting the position detection, it does not cause degradation of the detection precision. Therefore, high precision alignment is assured.

Where a piezoelectric device is used as the driving means 21 for the mirror GM to oscillate the alignment light and where a CCD sensor is used as the detecting means 11, the relationship between the voltage to be applied to the piezoelectric device and the output signal from the detecting means is such as shown in Figure 9.

While this embodiment uses a galvano mirror for oscillation of the alignment light, an acousto-optic element (AO) may be used as shown in Figure 13, with substantially the same advantageous effects.

In Figure 13, laser light source 13 is driven and controlled by a driving means 105, and the laser light from the source 13 is transformed by a collimator lens 102 into a parallel light which in turn is incident on an acousto-optic element 103. Driving means 104 controls the oscillation frequency to be applied to the acousto-optic element 103, and it controls the light (diffraction light) emanating from the element 103 by forming a phase grating within the element 103.

In this example, only light L1 of first order is used and, therefore, the other lights such as zero-th order light L0 and second order light L2 are intercepted by a blocking plate 106. By periodically changing the oscillation frequency to be applied by the driving means 104 to the acousto-optic element 103, the first order light L1 emanating therefrom is oscillated by small amount.

In these embodiments of the present invention, the alignment light is oscillated on the surface of a mask or a wafer in a direction not affecting the position detection. This assuredly avoids the adverse effects of speckle noise resulting from scattered light from an irregular surface portion of a mask or a wafer in a case where a laser light having good coherency is used as a light source means. Owing to this and to the resultant averaging effect as described, the present invention assures a position detecting system by which any positional deviation of the mask and the wafer can be detected very precisely. Also, it is possible to reduce speckle noise without enlargement in structure of the device.

In the embodiments of the present invention as described hereinbefore, an alignment beam and an article to be examined are relatively oscillated by small amount, within a charge accumulation time period of a light intensity detecting sensor such as CCD to thereby reduce the effect of speckle noise. However, the present invention is not limited to this form. As an example, the alignment beam and the article may be relatively oscillated with a period slower than the charge accumulation time period of the sensor and, from each of signals obtainable at certain time intervals, a corresponding quantity of positional deviation or a corresponding quantity of spacing (between the mask and the wafer) may be detected. Then, the obtained quantities of the positional deviation or the spacing may be averaged to determine the actual positional deviation or the actual spacing. Since in this example the speed of relative motion of the alignment beam and the article being examined in a direction not affecting the position detection, may be slow, it is not always necessary to use a piezoelectric device for the oscillation.

Further, while in the Figure 4A/4B embodiment the wafer 2 is oscillatingly moved, the mask may be oscillated in place thereof. Alternatively, both of the mask and the wafer may be oscillated. As a further alternative, an article to be examined may be oscillatingly moved while on the other hand an inspecting beam may be scanningly oscillated.

Also, clearly the present invention is applicable to a system such as shown in Figure 1, 2 or 3.

Moreover, the present invention is not limited to an exposure apparatus of proximity type, but is applicable also to a projection type exposure apparatus, an electron beam pattern drawing apparatus or a laser beam pattern drawing apparatus.

**Claims**

1. A position detecting method comprising the steps of

    projecting a radiation beam onto a surface of a substrate (60); and
    directing a resultant beam of radiation beam from the substrate to a predetermined plane, the radiation beam from the substrate being substantially focused at the predetermined plane;

characterised by relatively moving the radiation beam and the substrate in a direction parallel to the surface of the substrate which does not adversely affect the position detection while maintaining constant the angle of incidence of the radiation beam with respect to the substrate, such that the radiation beam produces a plurality of intensity distributions at the predetermined plane; and

determining the position of the substrate on the basis of the position of incidence of the radiation beam upon the predetermined plane measured by either the centre of gravity position or peak position of the light intensity distribution, said centre of gravity position or peak position being defined by superposition of (a) the intensity distributions or (b) the centre of gravity positions or peak positions of the intensity distributions.

2. A method as claimed in claim 1, characterised in that a substrate (60) is provided having an alignment mark (3) formed thereon.

3. A method as claimed in claim 1 or 2, characterised in that the radiation beam and the substrate are oscillated with respect to each other.

4. A method as claimed in claim 3, characterised in that the oscillation is by displacement of the substrate.

5. A method as claimed in claim 3, characterised in that the oscillation is by displacement of the radiation beam.

6. A method as claimed in any one of claims 1 to 5, characterised in that said position determining step determines position based on the centre of gravity of the superposed intensity distributions.

7. A method as claimed in any one of claims 1 to 5, characterised in that said position determining step determines the centre of gravity position by superposing the centre of gravity positions of the intensity distributions.

8. A method of aligning a mask (68) and a substrate (60) provided with alignment marks respectively, using the position detection method as claimed in any one of claims 1 to 7, wherein the radiation beam is projected by way of the mask mark on to the substrate mark which reflects the beam onto said predetermined plane, and including the step of correcting any positional deviation on the basis of said determining step.

9. An alignment apparatus for carrying out the method as claimed in claim 8, wherein positional deviation between a mask (68) and the substrate (60) is determined by using alignment mark of the mask having optical power with respect to a first direction and an alignment mark of the substrate having an optical power with respect to the first direction, said apparatus including a first holder for holding the mask, a second holder for holding the substrate, projecting means for projecting a radiation beam to the mask mark and the substrate mark, whereby a signal beam is produced, detecting means (11) for detecting an intensity distribution formed at the predetermined plane by the signal beam, shifting means (18) for relatively moving at least one of the mask mark and the substrate mark relatively to the radiation beam in a second direction substantially perpendicular to the first direction to thereby change the intensity distribution on said predetermined plane, and determining means (20) for determining the position of incidence of the signal beam at said predetermined plane based on said different intensity distributions formed through the operation of said shifting means to determine the position or deviation between the mask and the substrate whereby the correction for alignment can be effected.

10. A method of manufacturing a semi-conductor device comprising the steps of claim 8, including exposing the substrate to form a circuit pattern on the substrate, and fabricating a semi-conductor device using the substrate.

11. An alignment and exposure apparatus for carrying out the method as claimed in claim 10, comprising a first holder for holding the mask, a second holder for holding the substrate, projecting means for projecting a radiation beam to the mask mark and the substrate mark, whereby a signal beam is produced, detecting means (11) for detecting an intensity distribution formed on the predetermined plane by the signal beam;

shifting means (18) for relatively moving at least one of the mask mark and the substrate mark relatively to the radiation beam in a second direction substantially perpendicular to the first direction to thereby change the intensity distribution at said predetermined plane; determining means (20) for determining the position of incidence of the signal beam on said predetermined plane based on said different intensity distributions formed through the operation of said shifting means to determine the positional deviation between the mask and the substrate whereby the correction for alignment can be effected; and exposure means for transferring the circuit pattern of the mask on to the substrate.

**Patentansprüche**

1. Verfahren zum Erfassen der Lage, welches die Schritte aufweist:

   - Projizierens eines Energiestrahls auf eine Oberfläche eines Substrats **(60)**, und
   - Ausrichten eines resultierenden Energiestrahls vom Substrat auf eine vorbestimmte Ebene, so daß der Energiestrahl vom Substrat im wesentlichen auf die vorbestimmte Ebene fokussiert ist,

   **gekennzeichnet durch** das relative Bewegen des Energiestrahls und des Substrats in einer Richtung parallel zu der Oberfläche des Substrats, welche die Lageerfassung während des gleichbleibenden Erhaltens des Einfallswinkels des Energiestrahls mit Bezug auf das Substrat nicht nachteilig beeinflußt, so daß der Energiestrahl eine Vielzahl von Intensitätsverteilungen in der vorbestimmten Ebene aufweist, und

   - Bestimmen der Lage des Substrats auf der Grundlage der Einfallsposition des Energiestrahls auf der vorbestimmten Ebene durch das Messen entweder der Schwerpunktposition oder der Spitzenposition der Lichtstärkeverteilung, in welcher die Schwerpunktposition oder die Spitzenposition durch des Überlagern

      (a) der Intensitätsverteilungen oder
      (b) der Schwerpunktpositionen oder der Spitzenpositionen der Intensitätsverteilungen bestimmt wird.

2. Verfahren gemäß Anspruch 1,
   **dadurch gekennzeichnet, daß** ein Substrat **(60)** angeordnet ist, welches eine darauf ausgebildete Justiermarke **(3)** aufweist.

3. Verfahren gemäß Anspruch 1 oder 2,
   **dadurch gekennzeichnet, daß** der Energiestrahl und das Substrat mit Bezug zueinander schwingend bewegt werden.

4. Verfahren gemäß Anspruch 3,
   **dadurch gekennzeichnet, daß** das schwingende Bewegen durch Verschieben des Substrats erfolgt.

5. Verfahren gemäß Anspruch 3,
   **dadurch gekennzeichnet, daß** das schwingende Bewegen durch Verschieben des Energiestrahls erfolgt.

6. Verfahren gemäß einem der Ansprüche 1 bis 5,
   **dadurch gekennzeichnet, daß** der Lagebestimmungsschritt die Lage auf der Grundlage des Schwerpunkts der überlagerten Intensitätsverteilungen bestimmt.

7. Verfahren gemäß einem der Ansprüche 1 bis 5,
   **dadurch gekennzeichnet, daß** der Lagebestimmungsschritt die Schwerpunktposition durch Überlagern der Schwerpunktpositionen der Intensitätsverteilungen bestimmt.

8. Verfahren zum Justieren einer Maske **(68)** und eines Substrats **(60),** welche jeweils mit Justiermarken versehen sind, unter Verwendung des Verfahrens zum Erfassen der Lage gemäß einem der Ansprüche 1 bis 7, wobei der Energiestrahl über die Maskenmarke auf die Substratmarke projiziert wird, welche den Strahl auf die vorbestimmte Ebene reflektiert und den Schritt des Korrigierens jeder Lageabweichung auf der Grundlage des Bestimmungsschritts aufweist.

9. Justiervorrichtung zum Ausführen des Verfahrens gemäß Anspruch 8, wobei die Lageabweichung zwischen einer Maske **(68)** und dem Substrat **(60)** durch Verwenden der Justiermarke der Maske bestimmt wird, welche eine optische Brechkraft mit Bezug auf eine erste Richtung aufweist, und einer Justiermarke des Substrats, welche eine optische Brechkraft mit Bezug auf die erste Richtung aufweist, und die Vorrichtung aufweist:

   - eine erste Halteeinrichtung zum Halten der Maske,
   - eine zweite Halteeinrichtung zum Halten des Substrats,
   - eine Projektionseinrichtung zum Projizieren eines Energiestrahls auf die Maskenmarke und die Substratmarke, wobei ein Signalstrahl erzeugt wird,
   - eine Erfassungseinrichtung **(11)** zum Erfassen einer Intensitätsverteilung, welche auf der vorbestimmten Ebene durch den Signalstrahl erzeugt wird,
   - eine Verschiebungseinrichtung **(18)** zum relativen Bewegen mindestens jeweils der Maskenmarke und der Substratmarke relativ zum Energiestrahl in einer zweiten Richtung, im wesentlichen senkrecht zu der ersten Richtung, um dadurch die Intensitätsverteilung auf der vorbestimmten Ebene zu ändern, und
   - eine Bestimmungseinrichtung **(20)** zum Bestimmen der Einfallsposition des Signalstrahls auf der vorbestimmten Ebene auf der Grundlage der unterschiedlichen Intensitätsverteilungen, welche durch die Operation der Verschiebungseinrichtung erzeugt werden, um die Lage oder die Abweichung zwischen der Maske und dem Substrat zu bestimmen, wobei die Korrektur zum Justieren ausführbar ist.

10. Verfahren zur Herstellung einer Halbleitereinrichtung, welches die Schritte des Anspruchs 8 aufweist, einschließlich des Belichtens des Substrats, um eine Schaltungsstruktur auf dem Substrat zu erzeugen, und des Herstellens einer Halbleitereinrichtung unter Verwendung des Substrats.

11. Justier- und Belichtungsvorrichtung zum Ausführen des Verfahrens gemäß Anspruch 10, welches aufweist:

    -  eine erste Halteeinrichtung zum Halten der Maske,
    -  eine zweite Halteeinrichtung zum Halten des Substrats,
    -  eine Projektionseinrichtung zum Projizieren eines Energiestrahls auf die Maskenmarke und die Substratmarke, wobei ein Signalstrahl erzeugt wird,
    -  eine Erfassungseinrichtung (11) zum Erfassen einer Intensitätsverteilung, welche durch den Signalstrahl auf der vorbestimmten Ebene erzeugt wird,
    -  eine Verschiebeeinrichtung (18) zum relativen Bewegen mindestens jeweils der Maskenmarke und der Substratmarke relativ zum Energiestrahl in einer zweiten Richtung, im wesentlichen senkrecht zu der ersten Richtung, um dadurch die Intensitätsverteilung auf der vorbestimmten Ebene zu ändern,
    -  eine Bestimmungseinrichtung (20) zum Bestimmen der Einfallsposition des Signalstrahls auf der vorbestimmten Ebene auf der Grundlage der unterschiedlichen Intensitätsverteilungen, welche durch die Operation der Verschiebeeinrichtung zum Bestimmen der Lageabweichung zwischen der Maske und dem Substrat erzeugt werden, wobei die Korrektur zum Justieren ausführbar ist, und
    -  eine Belichtungseinrichtung zum Übertragen der Schaltungsstruktur der Maske auf das Substrat.

**Revendications**

1. Procédé de détection de position comprenant les étapes dans lesquelles

    on projette un faisceau de rayonnement sur une surface d'un substrat (60) ; et
    on dirige un faisceau résultant du faisceau de rayonnement depuis le substrat vers un plan prédéterminé, le faisceau de rayonnement provenant du substrat étant sensiblement focalisé au plan prédéterminé ;

caractérisé en ce qu'on procède à un mouvement relatif du faisceau de rayonnement du substrat dans une direction parallèle à la surface du substrat, ce qui ne nuit pas à la détection de la position, tout en maintenant constant l'angle d'incidence du faisceau de rayonnement par rapport au substrat, afin que le faisceau de rayonnement produise plusieurs répartitions d'intensité au plan prédéterminé ; et

on détermine la position du substrat sur la base de la position d'incidence du faisceau de rayonnement sur le plan prédéterminé, mesuré soit par la position du centre de gravité, soit par la position du pic de la répartition d'intensité lumineuse, ladite position du centre de gravité ou la position du pic étant définie par une superposition de (a) les répartitions d'intensité ou (b) les positions du centre de gravité ou les positions du pic des répartitions d'intensité.

2. Procédé selon la revendication 1, caractérisé en ce qu'il est prévu un substrat (60) sur lequel est formé un repère d'alignement (3).

3. Procédé selon la revendication 1 ou 2, caractérisé en ce qu'on fait osciller le faisceau de rayonnement et le substrat l'un par rapport à l'autre.

4. Procédé selon la revendication 3, caractérisé en ce que l'oscillation est produite par un déplacement du substrat.

5. Procédé selon la revendication 3, caractérisé en ce que l'oscillation est produite par un déplacement du faisceau de rayonnement.

6. Procédé selon l'une quelconque des revendications 1 à 5, caractérisé en ce que ladite étape de détermination de position détermine une position basée sur le centre de gravité des répartitions d'intensité superposées.

7. Procédé selon l'une quelconque des revendications 1 à 5, caractérisé en ce que ladite étape de détermination de position détermine la position du centre de gravité en superposant les positions de centre de gravité des répartitions d'intensité.

8. Procédé d'alignement d'un masque (68) et d'un substrat (60) pourvu de repères d'alignement, respectivement, utilisant le procédé de détection de position selon l'une quelconque des revendications 1 à 7, dans lequel le faisceau de rayonnement est projeté au moyen du repère du masque sur le repère du substrat qui réfléchit le faisceau sur ledit plan prédéterminé, et comprenant l'étape de correction de tout écart de position sur la base de ladite étape de détermination.

9. Appareil d'alignement pour la mise en oeuvre du procédé selon la revendication 8, dans lequel un écart de position entre un masque (68) et le substrat (60) est déterminé par l'utilisation d'un repère d'alignement du masque ayant une puissance optique par rapport à une première direction et un repère d'alignement du substrat ayant une puissance optique par rapport à la première direction, ledit appareil comprenant un premier support destiné à supporter le masque, un second support destiné à supporter le substrat, des moyens de projection destinés à projeter un faisceau de rayonnement sur le repère du masque et le repère du substrat, grâce à quoi un faisceau de signal est produit, des moyens de détection (11) destinés à détecter une répartition d'intensité formée au plan prédéterminé par le faisceau de signal, des moyens de déplacement (18) destinés à produire un mouvement relatif d'au moins l'un du repère du masque et du repère du substrat par rapport au faisceau de rayonnement dans une seconde direction sensiblement perpendiculaire à la première direction afin de modifier la répartition d'intensité sur ledit plan prédéterminé, et des moyens de détermination (20) destinés à déterminer la position d'incidence du faisceau de signal audit plan prédéterminé sur la base desdites répartitions d'intensité différentes formées par l'action desdits moyens de déplacement pour déterminer la position ou l'écart entre le masque et le substrat, afin que la correction pour l'alignement puisse être effectuée.

10. Procédé de fabrication d'un dispositif à semiconducteurs, comprenant les étapes de la revendication 8, comprenant l'exposition du substrat pour former un motif de circuit sur le substrat, et la fabrication d'un dispositif à semiconducteurs en utilisant le substrat.

11. Appareil d'alignement et d'exposition pour la mise en oeuvre du procédé selon la revendication 10, comportant un premier support destiné à supporter le masque, un second support destiné à supporter le substrat, des moyens de projection destinés à projeter un faisceau de rayonnement sur le repère du masque et le repère du substrat, grâce à quoi un faisceau de signal est produit, des moyens de détection (11) destinés à détecter une répartition d'intensité formée sur le plan prédéterminé par le faisceau de signal ;

des moyens de déplacement (18) destinés à produire un mouvement relatif d'au moins l'un du repère du masque et du repère du substrat par rapport au faisceau de rayonnement dans une seconde direction sensiblement perpendiculaire à la première direction afin de modifier la répartition d'intensité audit plan prédéterminé ;

des moyens de détermination (20) destinés à déterminer la position d'incidence du faisceau du signal sur ledit plan prédéterminé sur la base desdites répartitions d'intensité différentes formées par l'action desdits moyens de déplacement pour déterminer l'écart de position entre le masque et le substrat afin que la correction pour l'alignement puisse être effectuée ; et des moyens d'exposition destinés à transférer le motif de circuit du masque sur le substrat.

# F I G. 1

# F I G. 2

F I G. 3

F I G. 4A

## F I G. 4B

## F I G. 5

## F I G. 6

LIGHT INTENSITY

POSITION ON DETECTOR SURFACE

# F I G. 7

11a  11b  11c

11

X-AXIS
DIRECTION

# F I G. 8

OUTPUT
SIGNAL

TIME

APPLIED
VOLTAGE

TIME

# F I G. 9

FIG. IOA

FIG. IOB

FIG. IOC

F I G. IIA

F I G. IIB

LIGHT OSCILLATING DIRECTION

ALIGNMENT MARK

Y

X

ALIGMENT DIRECTION

FIG. 12

DRIVE — 105

101

102

DRIVE — 104

ACOUTO-OPTIC DEVICE — 103

L2

L0

106

L1

106

FIG. 13

EP 0 474 487 B1